## Europäisches Patentamt
## European Patent Office
## Office européen des brevets

(19)

(11) Veröffentlichungsnummer: **0 128 993**
**B1**

(12) **EUROPÄISCHE PATENTSCHRIFT**

(45) Veröffentlichungstag der Patentschrift:
**03.06.87**

(21) Anmeldenummer: **83810265.5**

(22) Anmeldetag: **17.06.83**

(51) Int. Cl.⁴: **G 03 B  41/00, H 01 L  23/52**

(54) Verfahren zum Feststellen von Referenzdaten zum Zwecke der Korrektur von mechanischen Bewegungen beim Schreiben von Linien mit einem Schreiblaserstrahl in einem metallisierten Raster und Vorrichtung zur Durchführung des Verfahrens.

(43) Veröffentlichungstag der Anmeldung:
**27.12.84 Patentblatt 84/52**

(45) Bekanntmachung des Hinweises auf die Patenterteilung:
**03.06.87 Patentblatt 87/23**

(84) Benannte Vertragsstaaten:
**AT BE CH DE FR GB IT LI LU NL SE**

(56) Entgegenhaltungen:
**US - A - 4 240 094**

**PATENTS ABSTRACTS OF JAPAN, Band 5, Nr. 186
(E-84)(858), 25. November 1981**

(73) Patentinhaber: **LASARRAY HOLDING AG,
CH-8512 Thundorf (CH)**

(72) Erfinder: **Steffen, Jürg, Dr., Dorf, CH-3655 Sigriswil (CH)**
Erfinder: **Percival, Richard Kent, Johannes Hirt
Strasse 31, CH-8804 Au ZH (CH)**

(74) Vertreter: **Frauenknecht, Alois J. et al, c/o PPS
Polyvalent Patent Service AG Mellingerstrasse 1,
CH-5400 Baden (CH)**

### Beschreibung

Die vorliegende Erfindung bezieht sich auf ein Verfahren zum Feststellen von Referenzdaten zum Zwecke der Korrektur von mechanischen Bewegungen beim Schreiben von Linien mit einem Schreiblaserstrahl in einem metallisierten Raster, das sich auf einem nichtmetallischen Werkstück befindet, und auf eine Vorrichtung zur Durchführung des Verfahrens.

In der EP-A-0 088 045 [zu berücksichtigen gemäss Artikel 54(3)] ist ein Verfahren zur Herstellung galvanisch leitender Bereiche in integrierten monolythischen Halbleiteranordnungen auf einer vorfabrizierten Halbleiterscheibe mit mehrfach vorhandenen P- und N- resp. N- und P-Strukturen, sowie über diesen Strukturen zumindest partiell regelmässig wiederkehrenden Kontaktflächen beschrieben. Die Ebene der Kontaktflächen ist durch eine erste, mit Aussparungen versehene, isolierende Schicht abgedeckt, auf welcher eine zweite galvanisch leitende Schicht aufgebracht ist. Diese zweite galvanisch leitende Schicht ist wenigstens partiell mit den Kontaktflächen der Strukturen leitend verbunden. In einem ersten Verfahrensschritt wird die galvanisch leitende Schicht mit Aussparungen in einem vorgegebenen Raster hergestellt, deren Rasterabstand zumindest annähernd der minimalen Breite eines zu erzielenden galvanisch leitenden Bereichs entspricht. In einem zweiten Verfahrensschritt wird die leitende Schicht im Gebiet hintereinander angeordnete Aussparungen soweit linienförmig abgetragen, bis ein insularer leitender Bereich entsteht. Die linienförmige Abtragung wird direkt oder indirekt durch einen Laserstrahl erzeugt. Es ist selbstverständlich, dass bei diesem Verfahren die vorfabrizierte Halbleiterscheibe präzise in zwei gegenseitig senkrechten Richtungen geführt werden muss. Der Antrieb kann mittels handelsüblichen Motoren erfolgen. Die Praxis hat jedoch gezeigt, dass in einigen Fällen, in bezug auf die insbesondere kleinen Abmessungen des Rasters, Fehler bei der Herstellung der linienartigen Aussparungen entstehen.

Der vorliegenden Erfindung liegt die Aufgabe zugrunde, ein Verfahren und eine Vorrichtung der eingangs genannten Art zu schaffen, die eine präzise gegenseitige Führung des Schreiblaserstrahls in bezug auf das Werkstück – Halbleiterscheibe – ermöglicht und bei einem eventuell entstandenen Fehler diesen soweit korrigiert, dass die Qualität der integrierten Schaltung nicht beeinträchtigt ist.

Die vorgenannte Aufgabe wird erfindungsgemäss dadurch gelöst, dass das mit dem metallisierten Raster versehene nichtmetallische Werkstück, z.B. eine Siliziumscheibe, während der linienartigen Arbeitsbewegungen gleichzeitig mit einem Tastlaserstrahl abgetastet wird, dass der reflektierte Tastlaserstrahl in einem Strahlendetektor empfangen und danach ausgewertet wird, wobei der metallisierte Raster die Referenzstruktur bildet und die ausgewerteten Signale zur Korrektur der relativen Bewegung des Werkstückes und des Schreiblaserstrahles dienen. Der Vorteil dieses Verfahrens ist darin zu sehen, dass auch feine Linien mit einem Schreiblaserstrahl von 0,5 bis 2 µm Breite auf flachen Werkstücken, insbesondere Halbleiterscheiben von bis zu 6" Durchmesser, mit einer Schreibgeschwindigkeit von 100 bis 500 mm/s möglich sind. Die Linien sind senkrecht zur Bewegungsrichtung (y-Richtung) auf ± 0,5 bis 1,5 µm genau positioniert und in Bewegungsrichtung (x-Richtung) in ihrer Länge und Position auf ± 0,5 bis 1,5 µm gesteuert.

Es gibt erfindungsgemäss verschiedene Möglichkeiten, die Korrektur der relativen Bewegung des Werkstückes und des Schreiblaserstrahles zu erreichen. Diese Korrektur kann z.B. durch die Korrektur der Bewegung des Werkstückes durchgeführt werden. Eine andere Möglichkeit ist, die Korrektur durch die Einstellung wenigstens eines steuerbaren Umlenkspiegels durchzuführen. Nach einer weiteren Variante verwendet man die Kombination der beiden vorgenannten Korrekturen.

Bei der Korrektur der relativen Bewegung des Werkstückes und des Schreiblaserstrahles durch die Einstellung wenigstens eines steuerbaren Umlenkspiegels wird der Umlenkspiegel erfindungsgemäss galvanometrisch oder piezoelektrisch durchgeführt. Eine weitere vorteilhafte Möglichkeit besteht in einer akusto- oder elektrooptischen Einstellung.

Vorteilhaft wird der reflektierte Tastlaserstrahl auf einen Strahlendetektor, z.B. auf eine Differenzialfotodiode geführt. Dieses Verfahren ermöglicht ein einfaches Abtasten der bearbeiteten Fläche und ein zuverlässiges Auswerten des reflektierten Tastlaserstrahles.

Es ist ebenfalls zweckmässig, wenn der reflektierte Tastlaserstrahl auf einen einfachen Strahlendetektor geführt wird und wenn der steuerbare Umlenkspiegel mit kleiner Amplitude gewobbelt wird.

Zweckmässig werden sowohl der zum Werkstück geführte als auch der reflektierte Tastlaserstrahl und der zum Werkstück geführte Schreiblaserstrahl über denselben steuerbaren Umlenkspiegel geführt. Diese Lösung vereinfacht die Konstruktion und sichert gleichzeitig die Steuerung des Tastlaserstrahls und des Schreiblaserstrahls.

Es ist vorteilhaft, wenn der Tastlaserstrahl das Werkstück unter einem spitzen Winkel kontaktiert. Dadurch wird die Abtastung empfindlich auf Höhenunterschiede der Referenzstruktur und es wird eine einfache Einstellung der Optik an die Höhenposition des Werkstückes (Dickenvariationen) ermöglicht.

Es ist vorteilhaft, wenn der Schreiblaserstrahl einen spitzen Winkel mit der Senkrechten zu der Oberfläche des Werkstückes einschliesst. Dieser spitze Winkel beträgt z.B. 20°. Dadurch wird erreicht, dass die Laserstrahlen, insbesondere wenn sie linear polarisiert ist, besser adsorbiert werden und dass keine Rückflexion vom Werkstück den Laser in seiner Emission stören könnte. Ein weiterer Vorteil liegt darin, dass das vom Werkstück reflektierte Licht detektiert werden kann, z.B. zur Synchronisation der Laserstrahlung mit der Werkstückkontur und/oder zur Echtzeitkontrolle des Schreibvorganges, und schliesslich zur Beobachtung der ursprünglichen Einstellung bzw. Positionierung des Laserstrahles auf dem Werkstück.

Die Vorrichtung zur Durchführung des Verfahrens ist mit einem Schreiblaser versehen und enthält erfindungsgemäss zusätzlich einen Tastlaser, dem ein Strahlendetektor, z. B. eine Differenzialfotodiode zugeordnet ist, die an eine Steuervorrichtung zum Erreichen der gegenseitig richtigen Lage des Werkstückes und des Schreiblaserstrahls angeschlossen ist.

Nach einer zweckmässigen Weiterbildung ist die Steuervorrichtung durch einen Servoloop gebildet, der aus einer Serieschaltung eines Differenzverstärkers, eines Nulldurchgangsuchers und -schalters, eines Reglers, eines DC Hochspannungs-Operationsverstärkers und wenigstens eines Piezoelementes besteht. Diese Schaltung ermöglicht eine präzise Steuerung des steuerbaren Umlenkspiegels.

Zweckmässig sind die Umlenkspiegel und Linsen in einem optischen Kopf angeordnet, wobei dieser optische Kopf an beide Laser angeschlossen ist und in der unteren Fläche eine Bohrung für den Durchgang des Schreiblaserstrahles und des Tastlaserstrahles von den Lasern zu dem Werkstück aufweist. Der optische Kopf ermöglicht eine sichere Anordnung der Umlenkspiegel und der Linsen und dient gleichzeitig als mechanischer Schutz für diese empfindliche Optik.

Es ist vorteilhaft, wenn der optische Kopf auch den Strahlendetektor, z. B. die Differenzialfotodiode enthält.

Nach einer Weiterausbildung ist der optische Kopf mit einem Beobachtungssystem, z. B. mit einem Monokular versehen. Der Vorteil liegt darin, dass man mit dem Auge die richtige Lage und die Qualität der durchgeführten Arbeit einstellen und kontrollieren kann.

Der Erfindungsgegenstand wird anhand von vereinfachten Zeichnungen näher erläutert, wobei auch weitere Vorteile erwähnt werden. Es zeigt:

Fig. 1 ein vereinfacht gezeichnetes Funktionsschema des erfindungsgemässen Gegenstandes;

Fig. 2 einen Teil des Werkstücks mit dargestelltem Tastlaserstrahl und Schreiblaserstrahl, wobei auch das metallisierte Raster vereinfacht gezeigt ist;

Fig. 3 einen Ausschnitt aus der Fig. 2, wobei zusätzlich zum Taststrahlfleck auch schematisch die Verwendung einer Differenzialfotodiode dargestellt ist;

Fig. 4a eine Intensitätsverteilung des Taststrahlfleckes;

Fig. 4b eine reflektierte Intensitätsverteilung bei symmetrischer Position des Taststrahlfleckes;

Fig. 4c eine reflektierte Intensitätsverteilung bei asymmetrischer Position;

Fig. 5 eine schematische Darstellung der Optik;

Fig. 6 ein Blockschema der Steuerung des steuerbaren Umlenkspiegels;

Fig. 7 eine Ansicht von rechts an die erfindungsgemässe Vorrichtung, wobei der Schreiblaser, der sich hinter den dargestellten Bestandteilen befindet, in dieser Figur nicht dargestellt ist;

Fig. 8 eine schematische Darstellung in Draufsicht auf den Weg des Schreiblaserstrahls aus dem Schreiblaser bis in den optischen Kopf;

Fig. 9 eine Vorderansicht auf den optischen Kopf;

Fig. 10 eine Ansicht von unten auf den optischen Kopf;

Fig. 11 eine Darstellung des Schreiblaserstrahls- und des Taststrahlfleckens auf dem Werkstück in drei verschiedenen Höhenpositionen, und

Fig. 12a, b, 13, 14, 15a, b Ausführungsbeispiele eines steuerbaren Umlenkspiegels.

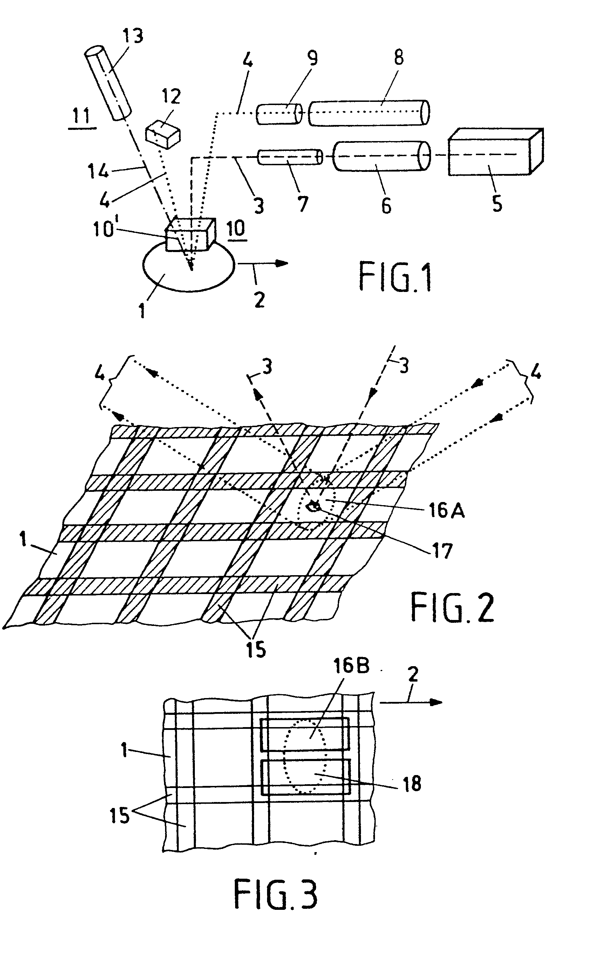

Fig. 1 zeigt ein vereinfachtes Funktionsschema der erfindungsgemässen Vorrichtung. Ein Werkstück 1 ist aus einer Siliziumplatte hergestellt und mit einem metallischen Raster versehen, der erst in den nächsten Zeichnungen gezeigt wird. Ein Pfeil 2 zeigt die Bewegungsrichtung des Werkstückes 1. Ein Schreiblaserstrahl 3 ist gestrichelt und ein Tastlaserstrahl punktiert gezeichnet. Der Schreiblaserstrahl 3 ist aus einem Schreiblaser 5 durch einen Modulator 6 mit einem elektrooptischen Strahlschalter und durch einen Schreibstrahlaufweiter 7 geführt. Der Tastlaserstrahl 4 ist aus einem Tastlaser 8 durch einen Taststrahlaufweiter 9 in einen optischen Kopf 10 geleitet, in dem auch Strahlablenker 10' angeordnet sind. Wegen der Übersichtlichkeit ist der Optikkopf 10 nur symbolisch in der Nähe des Werkstückes 1 gezeichnet, obwohl auch die Umlenkspiegel, die sich in den Biegepunkten des Schreiblaserstrahles 5 und des Tastlaserstrahles im oberen Teil der Fig. 1 befinden, selbstverständlich auch in diesem optischen Kopf 10 angeordnet sind. Ein Beobachtungssystem 11 ist durch ein Monokularmikroskop 13 und durch einen Beobachtungsstrahl 14 gebildet, wobei dieser Beobachtungsstrahl 14 die zu bearbeitende Fläche des Werkstückes kontaktiert und strichpunktiert gezeichnet ist. Symbolisch ist auch ein Strahlendetektor 12 gezeichnet, der den reflektierten Tastlaserstrahl 4 aufnimmt.

Die Fig. 2 zeigt einen Teil des Werkstückes 1 mit einem metallisierten Raster 15, der die Referenzstruktur bildet. Die Schraffierung bedeutet in diesem Beispiel keinen Schnitt. Sie soll die Zeichnung übersichtlicher machen. Der Tastlaserstrahl 4 bildet auf dem Werkstück 1 einen ebenfalls punktiert gezeichneten Taststrahlfleck 16A. Ein Schreibstrahlfleck 17 wird durch den Schreiblaserstrahl 3 gebildet. Mit den Pfeilen sind die Strahlungsrichtungen und die Richtungen der reflektierten Strahlen 3 und 4 gezeigt.

Fig. 3 zeigt einen Ausschnitt des Bildes der Werkstückoberfläche. Das Bild des Taststrahlfleckes 16B ist in dieser Figur in einer richtigen Position relativ zur Diode 18 gezeichnet.

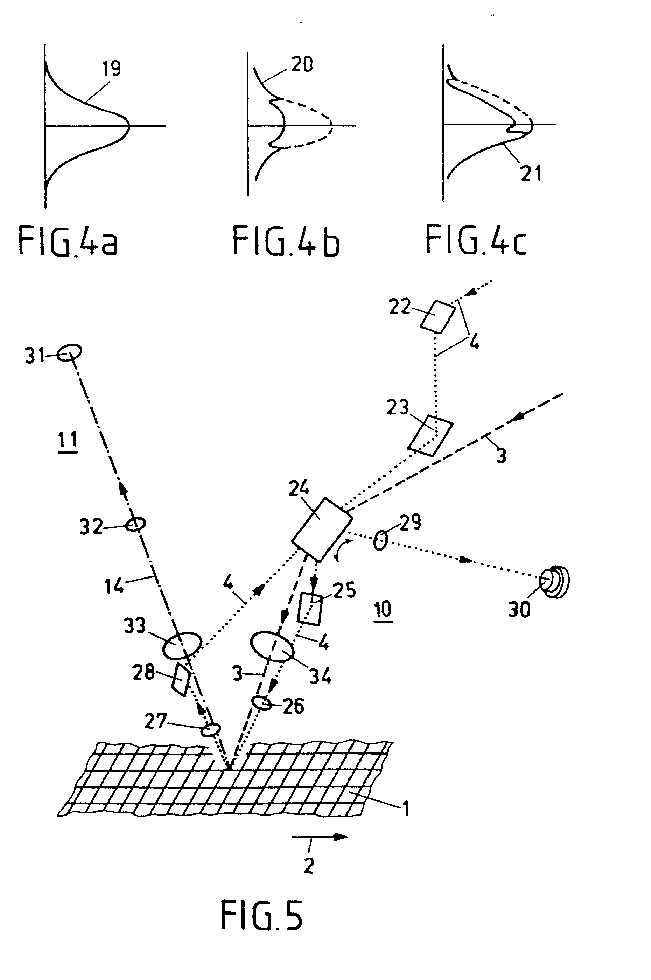

Die Fig. 4a zeigt eine Intensitätsverteilung 19 des Taststrahlfleckes 16 auf dem Werkstück 1. In der Fig. 4b ist eine reflektierte Intensitätsverteilung 20 voll gezeichnet, die der symmetrischen Position entspricht. Die Fig. 4c zeigt die reflektierte Intensitätsverteilung 21 bei asymmetrischer Position des Taststrahlfleckes 16.

Fig. 5 enthält eine schematische Darstellung der gesamten Optik. Es handelt sich im wesentlichen um den optischen Kopf 10 mit dem Beobachtungssystem 11. Der Tastlaserstrahl 4 ist zuerst über einen Umlenkspiegel 22 und einen weiteren justierbaren Umlenkspiegel 23 bis zu dem steuerbaren Umlenkspiegel 24 geführt. Von diesem wird der Tastlaserstrahl über einen weiteren Umlenkspiegel 25 und über eine Fokussierlinse 26 bis zu dem Werkstück 1 geführt. Von diesem Werkstück 1 wird der am Werkstück 1 reflektierte Tastlaserstrahl 4 durch eine weitere Fokussierlinse 27 geführt und mit einem Umlenkspiegel 28 retour zu dem steuerbaren Umlenkspiegel 24 geleitet. Von dem wird der Tastlaserstrahl durch ein optisches System 29, in diesem Fall durch eine Linse, auf die Funktionsfläche einer Differenzialfotodiode 30 geleitet, die dem Strahlendetektor 12 aus der Fig. 1 entspricht. Das Beobachtungssystem 11 besteht aus einem Beobachtungsokular 31 und aus zwei Linsen 32 und 33. Der Schreiblaserstrahl 3 führt auf den steuerbaren Umlenkspiegel 24, wovon er durch eine Fokussierlinse 34 auf das Werkstück 1 geführt wird. Wie schon in der Fig. 1 und 3, ist die Bewegungsrichtung des Werkstückes 1 mit dem Pfeil 2 gekennzeichnet.

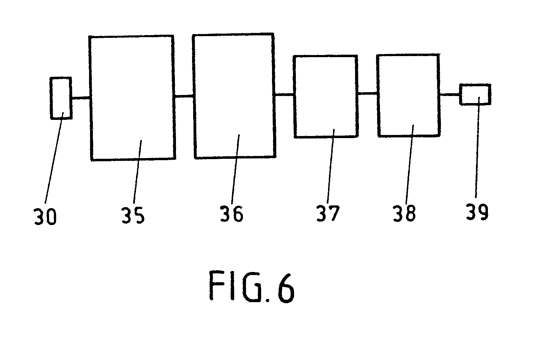

Fig. 6 stellt ein Blockschema der Steuerung des steuerbaren Umlenkspiegels 24 dar. Der sogenannte Servoloop ist von der Differenzialfotodiode 30 abgeleitet und durch eine Serieschaltung eines Differenzialverstärkers 35, eines Nulldurchgangsuchers und -schalters 36, eines Reglers 37, eines DC Hochspannungs-Operationsverstärkers 38 und wenigstens eines Piezoelementes 39 gebildet.

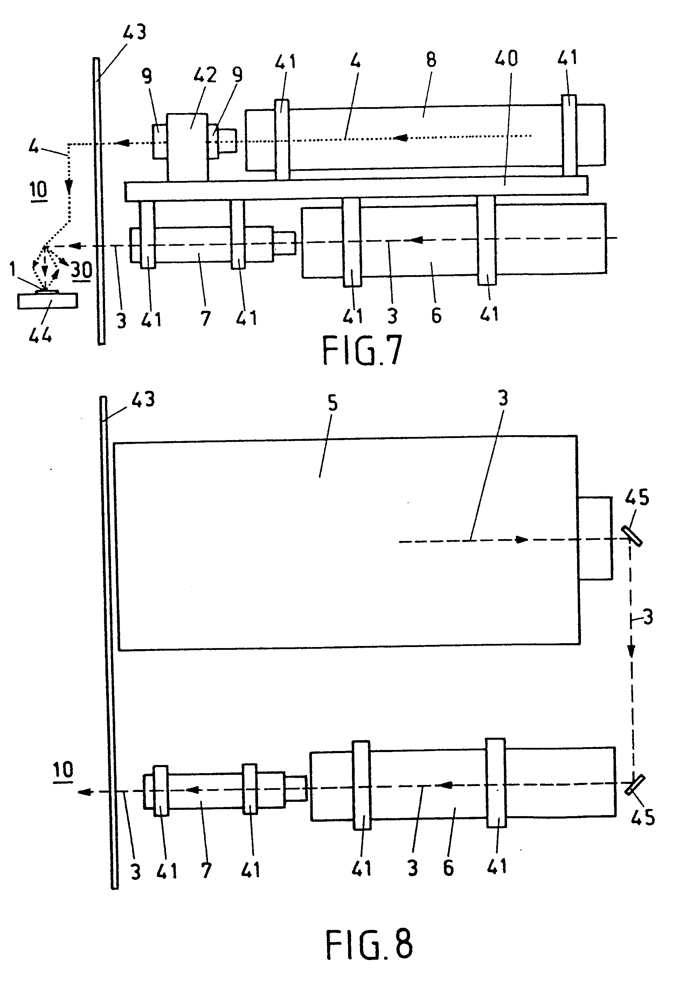

Fig. 7 zeigt eine Ansicht von rechts an die erfindungsgemässe Vorrichtung. Ein Modulator 6 mit einem elektrooptischen Strahlschalter führt den Schreiblaserstrahl 3 in einen Schreibstrahlaufweiter 7 und dann in den optischen Kopf 10. Der Tastlaserstrahl 4 wird aus dem Tastlaser 8 durch den Taststrahlaufweiter 9 in den optischen Kopf 10 geführt. Der Modulator 6, der Schreibstrahlaufweiter 7, der Tastlaser 8 und der Taststrahlaufweiter 9 sind mit Befestigungsrippen 41, bzw. mit einer Halterung 42 bei dem Taststrahlaufweiter 9, auf einer optischen Bank 40 gehalten. Unter dem optischen Kopf 10, der in dieser Fig. 7 wegen der Übersichtlichkeit nicht dargestellt ist, befindet sich ein in an sich bekannter Weise in beiden senkrechten Richtungen beweglicher Tisch 44, der auch drehbar angeordnet ist. Auf diesem beweglichen Tisch 44 ist das Werkstück 1 angeordnet. Die Richtungen beider Strahlen 3 und 4 sind wie in den früheren Zeichnungen gezeigt. Ein Pfeil führt nur zu der mit der Bezugsziffer 30 dargestellten Differenzialfotodiode, die sich ebenfalls in dem optischen Kopf 10 befindet.

In der Fig. 8 ist der Weg des Schreiblaserstrahls 3 aus dem Schreiblaser 5 in den optischen Kopf 10 gezeigt. Zusätzlich zu den schon beschriebenen Teilen sind in dieser Fig. 8 noch zwei Umlenkspiegel 45 gezeigt, die für die Leitung des Schreiblaserstrahls 3 aus dem Schreiblaser 5 in den optischen Kopf 10 dienen und eine raumsparende Konstruktion der Vorrichtung ermöglichen.

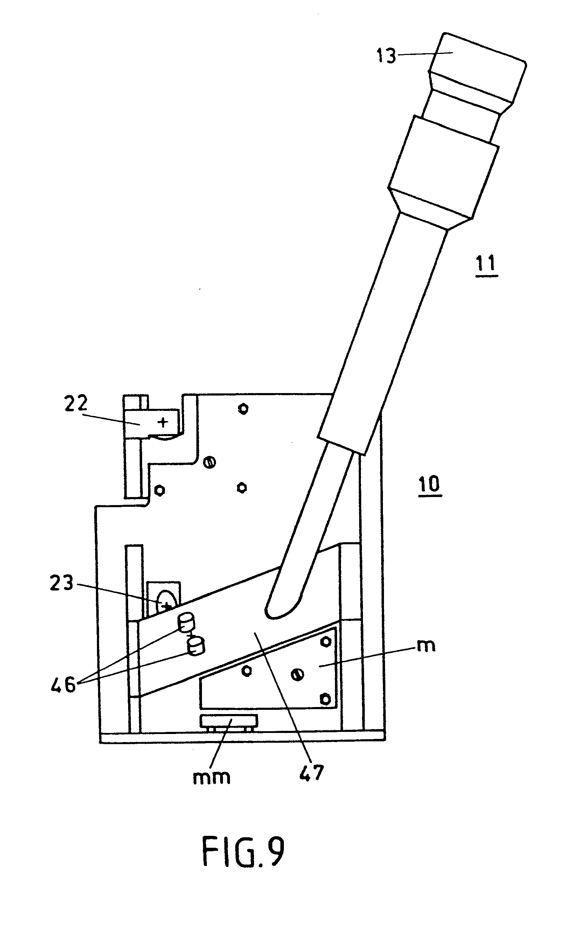

Fig. 9 zeigt eine Vorderansicht auf den optischen Kopf 10. In dieser Zeichnung ist die Anordnung des Beobachtungssystems 11 auf dem optischen Kopf 10 gut sichtbar. Das Monokularmikroskop ist mit 13 bezeichnet. Die optische Achse des Beobachtungssystems führt in das Innere des optischen Kopfes 10 und erreicht dann die barbeitete Fläche. Auf einer Leiste 47, die auch für die Halterung des Beobachtungssystems 11 dient, sind auch Anschlüsse 46 zur Steuerung des sich im Inneren des optischen Kopfes 10 befindenden, steuerbaren Umlenkspiegels 24 isoliert angeordnet. Der Umlenkspiegel 22 für den Tastlaserstrahl 4 ist mit drei Schrauben justierbar am optischen Kopf 10 befestigt. Mit dem + ist die Strahlachse bezeichnet. Der zweite Umlenkspiegel 23 für den Tastlaserstrahl 4 ist an dem optischen Kopf ebenfalls justierbar montiert. Eine justierbare Platte m trägt den Umlenkspiegel 28 und eine zweite Platte mm die Linse 27.

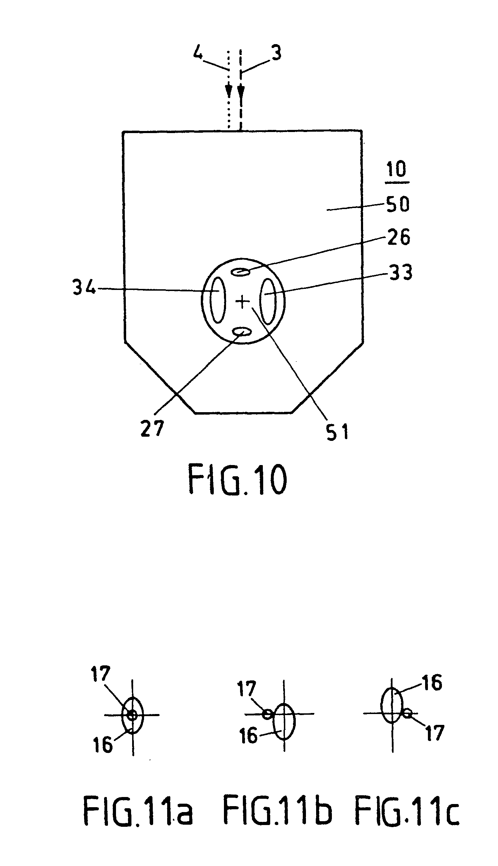

In der Fig. 10 ist eine Ansicht von unten auf den optischen Kopf 10 dargestellt. In der unteren Fläche 50 des optischen Kopfes 10 ist eine Bohrung 51 ausgeführt, durch welche die Strahlungen aus dem optischen Kopf 10 das Werkstück erreichen können und durch welche wieder die reflektierten Strahlen zurück auf die im optischen Kopf 10 sich befindenden optische Elemente reflektiert werden können. Durch diese Bohrung 5 können die Linsen 33 und 34 des Schreiblaserstrahlenganges und die Linsen 26 und 27 des Tastlaserstrahlenganges erkannt werden.

Die Fig. 11 zeigt drei Beispiele der Strahlflecken 16, 17 des Schreiblaserstrahles 3 und Tastlaserstrahles 4 auf der Werkstückoberfläche, wie sie durch das Monokularmikroskop 13 beobachtet werden können. + ist das Okularfadenkreuz. In der Fig. 11a ist die Werkstückoberfläche in korrekter Höhenposition. In Fig. 11b ist sie zu hoch und in Fig. 11c zu tief. Durch die schrägen Strahlauffallwinkel, sowohl des Schreiblaserstrahls 3 wie des Tastlaserstrahls 4, ist dadurch eine zusätzliche empfindliche Höheneinstellung und -kontrolle möglich, welche insbesondere bei dicken Variationen des Werkstückes wesentlich ist. Die Auflösung der Höhenmessung ergibt sich aus der Auflösung der lateralen Bewegung, z.B. 0,1 × Fleckengrösse und dem Auftreffwinkel von z.B. 20° zu 0,2 µm/tg 20° = 0,5 µm.

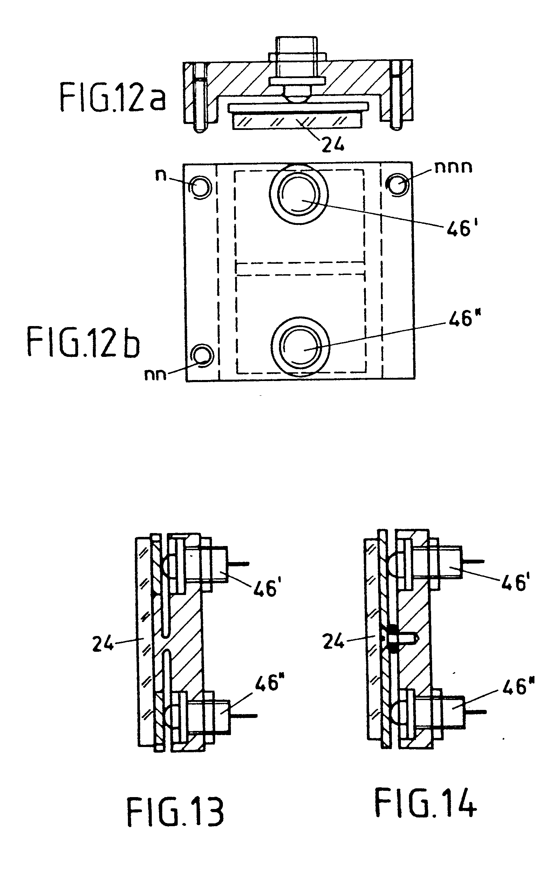

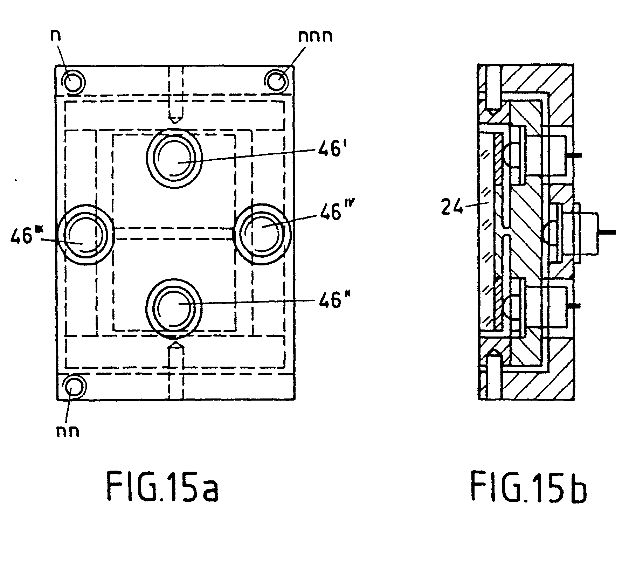

Fig. 12a, b zeigen Ausführungsbeispiele eines mit Hilfe piezoelektrischer Elemente über deren Anschlüsse 46′–46″ steuerbaren Umlenkspiegels 24. Gemäss Fig. 12a und 12b werden für eine eindimensionale Ablenkung zwei piezoelektrische Elemente in «pushpull»-Anordnung betrieben. Die piezoelektrischen Elemente sind in einem U-Profil festgeschraubt. An diesem Profil ist der bewegliche Spiegel 24 angebracht. Dieses U-Profil wird mit Justierschrauben n, nn, nnn auf dem optischen Kopf 10 befestigt. Die Fig. 13 und 14 zeigen Ausführungsformen der beweglichen Spiegelbefestigung. In der Lösung gemäss der Fig. 13 ist der bewegliche Spiegel durch eine elastische Deformation des Metallträgers gehalten und gemäss der Fig. 14 durch eine elastische Deformation eines Kautschukringes. Wesentlich ist dabei, dass die Drehachse möglichst auf der Spiegeloberfläche liegt. Eine Ausführungsform für zweidimensionale Ablenkung ist in den Fig. 15a und 15b dargestellt. Sie besteht im Prinzip aus einer Kombination zweier senkrecht zueinander stehender eindimensionaler Anordnungen mit piezoelektrischen Elementen mit Anschlüssen 46'–46".

Die Wirkungsweise des erfindungsgemässen Verfahrens und der Vorrichtung zur Durchführung des Verfahrens geht aus folgendem hervor. In der dargestellten Variante wurde die erfindungsgemässe Lösung gewählt, bei welcher die Korrektur mittels der Bewegung eines steuerbaren Umlenkspiegels 24 durchgeführt wird. Die Strahlenablenkung über ein Feld von bis zu 0,1524 m (6") mit einer Fleckgrösse von 0,5 bis 2 μm entfällt wegen der Beschränkung der Brennweite und numerischen Apertur der Fokussieroptik. Die Positionstoleranz von mechanischen Bewegungen bei den Geschwindigkeiten von 100 bis 500 mm/s ist meistens grösser als die gewünschten ± 0,5 bis 1,5 μm. Aus diesem Grund verwendet das erfindungsgemässe Verfahren zusätzlich zur mechanischen Bewegung in beiden senkrechten Bewegungsrichtungen des Werkstücks 1 und/oder des optischen Kopfes 10 ein Präzisionsstrahlablenkungssystem zur Kompensation der Bewegungsfehler des mechanischen Systems. Diese Strahlablenkung kann auch anders realisiert werden als dargestellt. Sie kann z.B. auch akusto- oder elektrooptisch durchgeführt werden. Der zu korrigierende Weg ist der Grössenordnung von 5 μm mit einer Auflösung von zirka 0,1 μm.

Die Brennweite des Fokussierungssystems ergibt sich aus dem gewünschten Fleckdurchmesser $d_f$ von 0,5 bis 2 μm und aus der Strahldivergenz $\alpha$ (halber Öffnungswinkel) des verwendeten Schreiblasers 5 (TEMoo-Mode) von typischerweise 0,5 mrad durch

$$F = \frac{d_f}{2\alpha} = 0,5 - 2 \text{ mm}$$

Die Strahldivergenz eines TEMoo-Mode-Lasers ergibt sich aus dessen Strahldurchmesser $d_o$ und Wellenlänge $\lambda$ des Lichtes

$$\alpha = 2\frac{\lambda}{\pi d_o}$$

Die Tiefenschärfe des Optiksystems (TEMoo-Mode-Laserstrahlung) ist

$$Z_F = \frac{8}{\pi} \lambda \left(\frac{F}{d_o}\right)^2 = \frac{\pi}{2\lambda} d_F^2$$

Das Fokussiersystem wird erfindungsgemäss aus einem Strahlaufweiter 7 (Teleskop) von 10 bis 40 X und einer Fokussierlinse der Brennweite von

$$F_o = 10 \times F \text{ bis } 40 \times F$$

zusammengesetzt, wobei der Strahlablenker 24 in einem Abstand von ca. $F_o$ vor dieser Fokussierlinse angeordnet wird. Durch Variation des Abstandes der Teleskoplinsen kann dadurch der Fleckdurchmesser $d_f$ und die sphärische Aberration des Fokussiersystems präzise eingestellt werden. Der Hauptzweck des Strahlaufweiters ist jedoch die Vergrösserung des freien Abstandes der Fokussierlinse von der Werkstückoberfläche, bzw. die Verwendung einer entsprechend grösseren Brennweite der Fokussierlinse $F_o$. Der resultierende gewünschte Ablenkwinkel ist in der Grössenordnung von $2,5 \cdot 10^{-4}$ rad und die Auflösung $2,5 \cdot 10^{-6}$ rad.

Die Korrektursignale für das Ablenksystem, in diesem Fall für den steuerbaren Umlenkspiegel 24, werden von einem Abtastsystem geliefert, welches eine Referenzstruktur 15, z.B. ein metallisiertes Raster, auf dem Werkstück 1 oder auf einer mit dem Werkstück 1 verbundenen Fläche abtastet (Fig. 2 und 3).

Erfindungsgemäss wird zum Abtasten ein Tastlaserstrahl 4 verwendet, dessen Wellenlänge und Leistung den Schreiblaserstrahl 3 nicht stört und welcher vom erwähnten Strahlablenksystem gleichzeitig mit dem Schreiblaserstrahl 3 abgelenkt wird, bevor er auf die abzutastende Fläche fällt. Die Position des Abtastlaserstrahles 3 auf der Referenzstruktur 15 wird durch Abbildung dieses Taststrahlfleckes 16 auf der Differenzialfotodiode 30 erreicht. Der reflektierte Tastlaserstrahl 4 verläuft durch das erwähnte Ablenksystem in symmetrischer Richtung. Anstelle der Differenzialfotodiode 30 kann man auch z.B. eine Modulation des Strahlablenksystems mit sehr kleiner Amplitude verwenden. Das erfindungsgemässe Verfahren ist insbesondere für das Schreiben von feinen Linien geeignet, z.B. zum Unterbrechen von elektrischen Verbindungen auf integrierten Schaltungen, welche auf Siliziumscheiben aufgebracht sind. Die Siliziumscheiben werden auf einem ebengeschliffenen Vakuumteller aufgespannt und in zwei gegenseitig senkrechten Richtungen (x- und y-Richtung) bewegt. Der lay-out der integrierten Schaltungen enthält ein regelmässiges, zweidimensionales, metallisiertes Raster 15.

Dieses Raster 15 dient in der erfindungsgemässen Vorrichtung als Referenzstruktur. Der Abstand zweier Rasterstreifen ist z.B. 7 μm und ihre Breite 5 μm (Fig. 2). Der Schreiblaser ist z.B. ein Argonionenlaser von 1 bis 5 mW Leistung bei 458 nm Wellenlänge (z.B. Spectra Physics, Mountain View, California, Mod. 162A.07; American Laser Corp., Salt Lake City, Utah, Mod. 60C), oder ein He-Cd-Laser von 1 bis 10 mW Leistung bei 442 nm, oder 1 bis 5 mW bei 325 nm.

Auch das Schalten der kontinuierlichen Laserleistung wird mit einem elektrooptischen Strahlschalter 6 (z.B. Coherent Inc., Palo Alto, California, Modulator Div. Mod. 3010) oder einem akustooptischen Strahlschalter 6 (z.B. Coherent Modulator Div. Mod. 304D) durchgeführt. Die benötigte Schaltzeit ergibt sich aus der Schreibgeschwindigkeit und der örtlichen Auflösung und ist z.B. μs. Der nachfolgende Strahlaufweiter 7 erhöht den Strahldurchmesser auf das Zehnfache. Der horizontale Strahl wird in nahezu vertikaler Richtung umgelenkt mit dem steuerbaren Umlenkspiegel 24, welcher mittels der Piezoelemente 39 um ± $10^{-4}$ bewegt werden kann. Die Fokussierlinse 34 besitzt in diesem Beispiel eine Brennweite von 18 mm und einen Durchmesser von 10 mm. Die resultierende Fleckgrösse ist etwa 2 μm und die Schärfentiefe ist etwa 13 μm. Der Schreiblaserstrahl 3 fällt unter einem Winkel von etwa 20° auf die Oberfläche des Werkstücks 1. Der an der Oberfläche reflektierte Schreiblaserstrahl 3 wird über die Linse 33 von 18 mm Brennweite und 10 mm Durchmesser entweder in einem Strahlendetektor 12, z.B. auf die Differenzialfotodiode 30, oder in ein Beobachtungssystem 11 geleitet, welches eine genügende Vergrösserung zur Einstellung aufweist. Dieses Beobachtungssystem 11 kann z.B. aus einer Linse 32 von f = 1,6 mm und 2 mm Durchmesser im Abstand von etwa 100 mm von der Linse 33 und einem Okular 31 mit Vergrösserung 25 × im Abstand 100 mm von der Linse 32 bestehen.

Der Tastlaser 8 ist in diesem Beispiel ein He-Ne-Laser von 1 mW Leistung und 0,65 mm Strahldurchmesser. Dieser wird mit einem Taststrahlaufweiter 9 auf das 4-fache vergrössert und mit einem justierbaren Spiegel 23 dem Schreiblaserstrahl 3 auf dem steuerbaren Spiegel 24 überlagert. Der vom steuerbaren Spiegel 24 reflektierte Tastlaserstrahl 4 wird mit einem weiteren Umlenkspiegel 25 durch eine Fokussierlinse 26 dem Schreiblaserstrahl 3 auf dem Werkstück 1 überlagert. Die Brennweite der Linse 28 wird so gewählt, dass der Durchmesser des Taststrahlfleckes 16 auf dem Werkstück der Referenzstruktur 15 optimal angepasst ist. Dieser Durchmesser kann durch Veränderung des Abstandes des Taststrahlaufweiters 9 fein variiert werden. Bevorzugterweise wird die Einfallsebene des Tastlaserstrahls 4 (das ist die Ebene, die durch die Achse des Tastlaserstrahls 4 und durch die Senkrechte zu dem Werkstück 1 gegeben ist) senkrecht zu der Einfallsebene des Schreiblaserstrahls 3 gewählt und zwar senkrecht zur Bewegungsrichtung des Werkstückes 1. Der vom Werkstück 1 reflektierte Tastlaserstrahl 4 wird symmetrisch zu der Senkrechten durch die Fokussierlinse 17 mit dem Umlenkspiegel 28 den in den Kopf eintretenden Schreibstrahl 3 und Tastlaserstrahl 4 auf dem Spiegel 24 überlagert und weiter über ein optisches System 29 auf die Differenzialdiode 30 geführt. Die Differenzialdiode 30 empfängt also eine Abbildung des bearbeiteten Teils der Oberfläche des Werkstückes 1.

Wenn sich nun die bewegte Siliziumplatte aus ihrer Soll-Lage senkrecht zur Bewegungsrichtung entfernt, entsteht auf der Differenzialdiode 30 ein Ungleichgewicht der auffallenden Intensität (siehe Fig. 3). Ein dem Differenzsignal proportionales Signal steuert über einen Servoloop die Stellung des steuerbaren Umlenkspiegels 24. Die Reaktionsgeschwindigkeit eines solchen Systems kann bei kleinem Winkel der Bewegung des steuerbaren Umlenkspiegels 24 bis in den 5 kHz-Bereich gehen. Der Servoloop wurde schon bei der Beschreibung der Fig. 6 erklärt. Der DC Hochspannungs-Operationsverstärker (z.B. Mod. PZ-70 von Burleigh Instruments Inc., Fishers, New York) dient zur Steuerung der Piezoelemente 39, die die Lage des steuerbaren Umlenkspiegels 24 beherrschen.

Bezeichnungsliste

| | | |
|---|---|---|
| 1 | = | Werkstück/Si-Platte |
| 2 | = | Bewegungsrichtung des Werkstücks 1 |
| 3 | = | Schreiblaserstrahl (gestrichelt) |
| 4 | = | Tastlaserstrahl (punktiert) |
| 5 | = | Schreiblaser (TEMoo-Mode) |
| 6 | = | Modulator/Elektrooptischer Strahlschalter |
| 7 | = | Schreibstrahlaufweiter |
| 8 | = | Tastlaser |
| 9 | = | Taststrahlaufweiter |
| 10 | = | optischer Kopf |
| 10' | = | Strahlablenker |
| 11 | = | Beobachtungssystem |
| 12 | = | Strahlendetektor |
| 13 | = | Monokularmikroskop |
| 14 | = | Beobachtungsstrahl (strichpunktiert) |
| 15 | = | metallisiertes Raster/Referenzstruktur |
| 16A, B | = | Taststrahlfleck |
| 17 | = | Schreibstrahlfleck |
| 18 | = | Diode |
| 19 | = | Intensitätsverteilung des Taststrahlfleckes 16 |
| 20 | = | reflektierte Intensitätsverteilung bei symmetrischer Position |
| 21 | = | reflektierte Intensitätsverteilung bei asymmetrischer Position |
| 22 | = | Umlenkspiegel für den Tastlaserstrahl 4 |
| 23 | = | justierbarer Spiegel für den Tastlaserstrahl 4 |
| 24 | = | steuerbarer Umlenkspiegel für den Tastlaserstrahl 4 und für den Schreiblaserstrahl 5 |
| 25 | = | Umlenkspiegel für den Tastlaserstrahl 4 |
| 26 | = | Fokussierlinse für den Tastlaserstrahl 4 |
| 27 | = | Fokussierlinse für den reflektierten Tastlaserstrahl 4 |
| 28 | = | Umlenkspiegel für den reflektierten Tastlaserstrahl 4 |
| 29 | = | optisches System |
| 30 | = | Differenzialfotodiode |
| 31 | = | Beobachtungsokular |
| 32 | = | Linse des Beobachtungssystems 11 |
| 33 | = | weitere Linse des Beobachtungssystems 11 |
| 34 | = | Fokussierlinse für den Schreiblaserstrahl 3 |
| 35 | = | Differenzverstärker |
| 36 | = | Nulldurchgangsucher und -schalter |
| 37 | = | Regler |
| 38 | = | DC Hochspannungs-Operationsverstärker |
| 39 | = | Piezoelemente |
| 40 | = | optische Bank |
| 41 | = | Befestigungsrippen |
| 42 | = | Halterung |
| 43 | = | Platte |
| 44 | = | beweglicher Tisch |
| 45 | = | Umlenkspiegel |

46'–46" = Anschlüsse der piezoelektrischen Elemente 39
47 = Leiste für Beobachtungssystem 11
m–mm = Platten
50 = untere Fläche des optischen Kopfes 10
51 = Bohrung in der unteren Fläche 10
n–nnn = Justierschrauben

## Patentansprüche

1. Verfahren zum Feststellen von Referenzdaten zum Zwecke der Korrektur von mechanischen Bewegungen beim Schreiben von Linien mit einem Schreiblaserstrahl (3) in einem metallisierten Raster (15), das sich auf einem nichtmetallischen Werkstück (1) befindet, dadurch gekennzeichnet, dass das mit dem metallisierten Raster (15) versehene nichtmetallische Werkstück (1), z.B. eine Siliziumscheibe, während der linienartigen Arbeitsbewegung gleichzeitig mit einem Tastlaserstrahl (4) abgetastet wird, dass der reflektierte Tastlaserstrahl (4) in einem Strahlendetektor (12) empfangen und danach ausgewertet wird, wobei der metallisierte Raster die Referenzstruktur bildet und die ausgewerteten Signale zur Korrektur der relativen Bewegung des Werkstückes (1) und des Schreiblaserstrahles (3) dienen.

2. Verfahren nach Anspruch 1, dadurch gekennzeichnet, dass die Korrektur der relativen Bewegung des Werkstückes (1) und des Schreiblaserstrahles (3) durch die Korrektur der Bewegung des Werkstückes (1) durchgeführt wird.

3. Verfahren nach Anspruch 1, dadurch gekennzeichnet, dass die Korrektur der relativen Bewegung des Werkstückes (1) und des Schreiblaserstrahles (3) durch die Einstellung wenigstens eines steuerbaren Umlenkspiegels (24) durchgeführt wird.

4. Verfahren nach Anspruch 1, dadurch gekennzeichnet, dass die Korrektur der relativen Bewegung des Werkstückes (1) und des Schreiblaserstrahles (3) durch die Kombination der Korrekturen der Bewegung des Werkstückes (1) und der Einstellung wenigstens eines steuerbaren Umlenkspiegels (24) durchgeführt wird.

5. Verfahren nach Anspruch 3, dadurch gekennzeichnet, dass die Einstellung des wenigstens einen steuerbaren Umlenkspiegels (24) galvanometrisch durchgeführt wird.

6. Verfahren nach Anspruch 3, dadurch gekennzeichnet, dass die Einstellung wenigstens einen steuerbaren Umlenkspiegels (24) piezoelektrisch durchgeführt wird.

7. Verfahren nach Anspruch 3, dadurch gekennzeichnet, dass die Einstellung des wenigstens einen steuerbaren Umlenkspiegels (24) akusto- oder elektrooptisch durchgeführt wird.

8. Verfahren nach Anspruch 1, dadurch gekennzeichnet, dass der reflektierte Tastlaserstrahl (4) auf einen Strahlendetektor (12), z.B. auf eine Differenzialfotodiode (30) geführt wird.

9. Verfahren nach Anspruch 1, dadurch gekennzeichnet, dass der reflektierte Tastlaserstrahl (4) auf einen einfachen Strahlendetektor (12) geführt wird und dass der steuerbare Umlenkspiegel (24) mit kleiner Amplitude gewobbelt wird.

10. Verfahren nach Anspruch 1, dadurch gekennzeichnet, dass sowohl der zum Werkstück (1) geführte als auch der reflektierte Tastlaserstrahl (4) und der zum Werkstück (1) geführte Schreiblaserstrahl (3) über denselben steuerbaren Umlenkspiegel (24) geführt werden.

11. Verfahren nach Anspruch 1, dadurch gekennzeichnet, dass der Tastlaserstrahl (4) das Werkstück (1) unter einem spitzen Winkel kontaktiert.

12. Verfahren nach Anspruch 1, dadurch gekennzeichnet, dass der Schreiblaserstrahl (3) einen spitzen Winkel mit der Senkrechten zu der Oberfläche des Werkstückes (1) einschliesst.

13. Vorrichtung zur Durchführung des Verfahrens nach Anspruch 1 mit einem Schreiblaser (5), dadurch gekennzeichnet, dass die Vorrichtung zusätzlich einen Tastlaser (8) enthält, dem ein Strahlendetektor (12), z.B. eine Differenzialfotodiode (30), zugeordnet ist, der an eine Steuervorrichtung zum Erreichen der gegenseitig richtigen Lage des Werkstückes (1) und des Schreiblaserstrahls (3) angeschlossen ist.

14. Vorrichtung nach Anspruch 13, dadurch gekennzeichnet, dass die Steuervorrichtung zum Erreichen der gegenseitig richtigen Lage des Werkstückes (1) und des Schreiblaserstrahls (3) durch einen Servoloop gebildet ist, der aus einer Serieschaltung eines Differenzverstärkers (35), eines Nulldurchgangsuchers und -schalters (36), eines Reglers (37), eines DC Hochspannungs-Operationsverstärkers (38) und wenigstens eines Piezoelementes (39) besteht.

15. Vorrichtung nach Anspruch 13, dadurch gekennzeichnet, dass sie mit einem optischen Kopf (10) versehen ist, in welchem Umlenkspiegel (22, 23, 24, 25, 28) und Linsen (26, 27, 29, 34) angeordnet sind, wobei dieser optische Kopf (10) an beide Laser (5, 8) angeschlossen ist und in der unteren Fläche (50) eine Bohrung (51) für den Durchgang des Schreiblaserstrahles (3) und des Tastlaserstrahles (4) von den Lasern (5, 8) zu dem Werkstück (1) aufweist.

16. Vorrichtung nach Anspruch 15, dadurch gekennzeichnet, dass der optische Kopf (10) eine Differenzialfotodiode (30) in Funktion eines Strahlendetektors (12) enthält.

17. Vorrichtung nach Anspruch 15, dadurch gekennzeichnet, dass der optische Kopf (10) mit einem Beobachtungssystem (11), z.B. mit einem Monokularmikroskop (13) versehen ist.

## Claims

1. A method of determining references for the correction of mechanical movements when inscribing lines in a metallised grid (15) on a non-metallic workpiece by means of an inscribing laser beam (3), characterised in that the non-metallic workpiece (1), e.g. a silicon disc, provided with the metallised grid (15) is simultaneously scanned during the linear operational movements with a scanning laser beam (4), that the reflected scanning laser beam (4) is received in a beam detector (12) and then evaluated, the metallised grid forming the reference structure and the evaluated signals being used to correct the relative movement between the workpiece (1) and the inscribing laser beam (3).

2. A method according to claim 1, characterised in that correction of the relative movement between the workpiece (1) and the inscribing laser beam (3) is carried out by correcting the movement of the workpiece (1).

3. A method according to claim 1, characterised in that correction of the relative movement between the workpiece (1) and the inscribing laser beam (3) is carried out by adjusting at least one controllable deflection mirror (24).

4. A method according to claim 1, characterised in that correction of the movement between the workpiece (1) and the inscribing laser beam (3) is carried out by combining the corrections of the movement of the workpiece (1) and adjusting at least one controllable deflection mirror (24).

5. A method according to claim 3, characterised in that the adjustment of at least one controllable deflection mirror (24) is carried out galvanometrically.

6. A method according to claim 3, characterised in that the adjustment of at least one controllable deflection mirror (24) is carried out piezo-electrically.

7. A method according to claim 3, characterised in that the adjustment of at least one controllable deflection mirror (24) is carried out acousto-optically or electro-optically.

8. A method according to claim 1, characterised in that the reflected scanning laser beam (4) is guided onto a beam detector (12), e.g. a differential photodiode (30).

9. A method according to claim 1, characterised in that the reflected scanning laser beam (4) is guided onto a single beam detector (12), and that the controllable deflection mirror (24) is swept back and forth at low amplitude.

10. A method according to claim 1, characterised in that both the reflected scanning laser beam (4) guided to the workpiece (1) and the inscribing laser beam (3) are guided via the same controllable deflection mirrors (24).

11. A method according to claim 1, characterised in that the scanning laser beam (4) makes contact with the workpiece (1) at an acute angle.

12. A method according to claim 1, characterised in that the inscribing laser beam (3) forms an acute angle with the perpendicular to the surface of the workpiece (1).

13. A device for carrying out the method according to claim 1 having a inscribing laser (5), characterised in that the device comprises in addition a scanning laser (8), a beam detector (12), e.g. a differential photodiode (30), associated therewith, the beam detector being connected to a control device for obtaining the mutually correct positions of the workpiece (1) and the inscribing laser beam (3).

14. A device according to claim 13, characterised in that the control device for obtaining the mutually correct positions of the workpiece (1) and the inscribing laser beam (3) is formed by a servo loop comprising, in series, a differential amplifier (35), a zero passage selector and switch (36), a regulator (37), a DC high voltage operation amplifier (38) and at least one piezo element (39).

15. A device according to claim 13, characterised in that the device is provided with an optical head (10) in which deflection mirrors (22, 23, 24, 25, 28) and lenses (26, 27, 29, 34) are arranged, the optical head (30) being connected to both lasers (5, 8) and having in the lower face (50) a borehole (51) for the passage of the inscribing laser beam (3) and the scanning laser beam (4) from the lasers (5, 8) to the workpiece (1).

16. A device according to claim 15, characterised in that the optical head (10) comprises a differential photodiode (30) having the function of a beam detector (12).

17. A device according to claim 15, characterised in that the optical head (10) is provided with an observation system (11), e.g. with a monocular microscope (13).

**Revendications**

1. Procédé de détermination de références pour la correction de mouvements mécaniques lors de l'écriture de lignes dans une trame métallisée (15) à l'aide d'un rayon laser (3), cette trame se situant sur une pièce (1) non métallique, caractérisé en ce que la pièce non métallique (1) munie de la trame métallisée (15), une pastille de silicium par exemple, est simultanément explorée par un rayon laser de balayage (4) pendant les mouvements en ligne, en ce que le rayon de balayage réfléchi (4) est reçu dans un détecteur de faisceau (12), puis analysé, la trame métallisée constituant la structure de référence et les signaux interprétés permettant de corriger le mouvement relatif entre la pièce (1) et le rayon laser d'écriture (3).

2. Procédé suivant la revendication 1, caractérisé en ce que la correction du mouvement relativ entre la pièce (1) et le rayon laser d'écriture (3) est assurée par une correction du mouvement de la pièce (1).

3. Procédé suivant la revendication 1, caractérisé en ce que la correction du mouvement relativ entre la pièce (1) et le rayon laser d'écriture (3) est assurée par le réglage d'un miroir déflecteur contrôlable (24) au moins.

4. Procédé suivant la revendication 1, caractérisé en ce que la correction du mouvement relatif entre la pièce (1) et le rayon laser d'écriture (3) est assurée par une combinaison des corrections du mouvement de la pièce (1) et du réglage d'un miroir déflecteur contrôlable au moins (24).

5. Procédé suivant la revendication 3, caractérisé par un réglage galvanométrique d'au moins un miroir déflecteur contrôlable (24).

6. Procédé suivant la revendication 3, caractérisé par un réglage piézoélectrique d'au moins un miroir déflecteur contrôlable (24).

7. Procédé suivant la revendication 3, caractérisé par un réglage acousto- ou électro-optique d'au moins un miroir déflecteur contrôlable (24).

8. Procédé suivant la revendication 1, caractérisé en ce que le rayon laser de balayage réfléchi (4) est dirigé sur un détecteur de faisceau (12), une photodiode différentielle (30) par exemple.

9. Procédé suivant la revendication 1, caractérisé en ce que le rayon laser de balayage réfléchi (4) est dirigé sur un simple détecteur de faisceau (12), et en ce que le miroir déflecteur réglable (24) est vobulé avec une faible amplitude.

10. Procédé suivant la revendication 1, caractérisé en ce que le rayon laser de balayage (4) envoyé sur la pièce (1) et réfléchi, ainsi que le rayon d'écriture (3) dirigé sur la pièce (1), sont réfléchis par le même miroir déflecteur réglable (24).

11. Procédé suivant la revendication 1, caractérisé en ce que le rayon laser de balayage (4) contacte la pièce (1) en formant un angle aigu.

12. Procédé suivant la revendication 1, caractérisé en ce que le rayon laser d'écriture (3) forme un angle aigu avec la perpendiculaire à la surface de la pièce (1).

13. Dispositif pour la réalisation du procédé conforme à la revendication 1, avec un laser d'écriture (5), caractérisé par un laser de balayage supplémentaire (8), auquel affecté un détecteur de faisceau (12), une photodiode différentielle (30) par exemple, raccordée à un dispositif de commande qui permet d'obtenir une position mutuelle exacte de la pièce (1) et du rayon laser d'écriture (3).

14. Dispositif suivant la revendication 13, caractérisé en ce que le système de commande, prévu pour obtenir la position mutuelle exacte de la pièce (1) et du rayon laser d'écriture (3), est représenté par une boucle asservie, formée par le montage en série d'un amplificateur différentiel (35), d'un commutateur et d'un détecteur de passage par zéro (36), d'un régulateur (37), d'un amplificateur opérationnel DC haute tension (38) et d'un élément piézoélectrique au moins (39).

15. Dispositif suivant la revendication 13, caractérisé par une tête optique (10), dans laquelle sont montés des miroirs déflecteurs (22, 23, 24, 25, 28) et les lentilles (26, 27, 29, 34), cette tête (10) étant raccordée à deux lasers (5, 8) et présentant sur sa face inférieure (50) un orifice (51) pour le passage des rayons laser d'écriture (3) et de balayage (4), transmis à la pièce (1) par les lasers (5, 8).

16. Dispositif suivant la revendication 15, caractérisé en ce que la tête optique (10) comporte un détecteur de faisceau (12), représenté par une photodiode différentielle (30).

17. Dispositif suivant la revendication 15, caractérisé en ce que la tête optique (10) est munie d'un système d'observation (11), un microscope monoculaire (13) par exemple.

FIG.1

FIG.2

FIG.3

FIG.4a    FIG.4b    FIG.4c

FIG.5

FIG.6

FIG.7

FIG.8

FIG.9

FIG.10

FIG.11a   FIG.11b   FIG.11c

FIG.12a

24

n

nnn

46'

46"

FIG.12b

nn

24

46'

46"

FIG.13

24

46'

46"

FIG.14

n                                    nnn

46'

46ᴵⱽ

46ᴹ

46"

nn

24

# FIG.15a                    FIG.15b